# FASCICULE DE BREVET EUROPEEN

(11) **EP 3 392 910 B1**
(45) Date de publication et mention de la délivrance du brevet: **13.12.2023**
(21) Numéro de dépôt: 18166608.2
(22) Date de dépôt: 10.04.2018
(51) Int. Cl.: H01L 27/146

(54) **BOITIER HERMETIQUE DE COMPOSANT ELECTRONIQUE, EN PARTICULIER POUR CAPTEUR D'IMAGE**
HERMETISCH VERSCHLOSSENES GEHÄUSE EINER ELEKTRONISCHEN KOMPONENTE, INSBESONDERE EINES BILDSENSORS
ENCAPSULATED HOUSING OF ELECTRONIC COMPONENT, IN PARTICULAR FOR IMAGE SENSOR

(30) Priorité: 18.04.2017 FR 1753335
(43) Date de publication de la demande: 24.10.2018
(73) Titulaire: Teledyne e2v Semiconductors SAS, 38120 Saint-Egrève (FR)
(72) Inventeur: SANDRI, Philippe, 38320 HERBEYS (FR); REBER, Pierre, 38620 MASSIEU (FR); ALLUIS, Charlotte, 38340 VOREPPE (FR); RIONDET, Laurent, 38180 SEYSSINS (FR)
(74) Mandataire: Atout PI Laplace

(56) Documents cités:
- EP-A1- 2 164 102
- EP-A2- 1 523 045
- EP-A2- 1 796 168

## Description

### DOMAINE TECHNIQUE

L'invention concerne un boitier hermétique de composant électronique, notamment pour les applications de l'aérospatiale. L'invention s'applique en particulier aux capteurs d'image.

### ETAT DE L'ART

L'encapsulation d'un composant électronique (puce nue ou composant) en boitier hermétique offre une protection mécanique et chimique contre des agressions liées à son environnement opérationnel extérieur. Dans certains cas, il s'agit également de maintenir un vide plus ou moins poussé (absence de gaz ou nature et quantité de gaz maîtrisées) dans la cavité interne du boitier pour permettre un fonctionnement correct du composant électronique placé dans cette cavité.

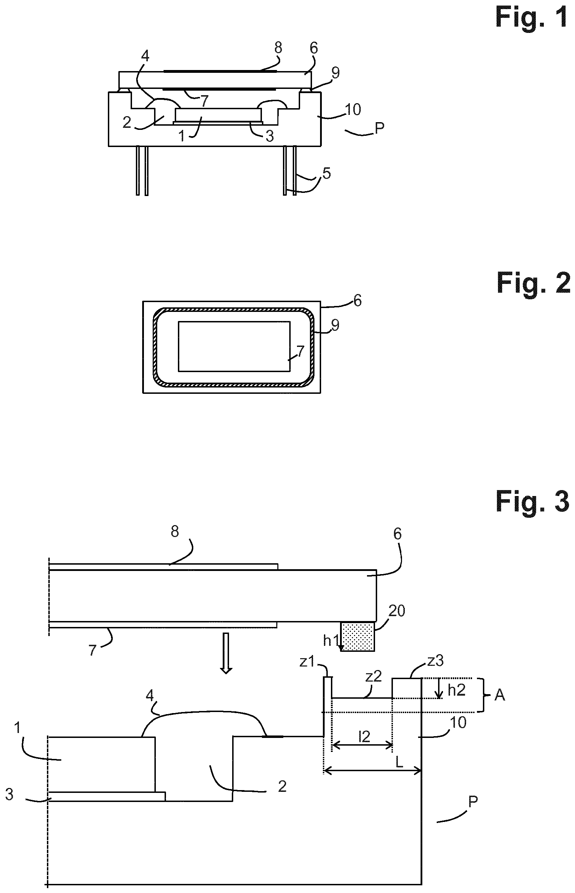

La figure 1 illustre par exemple l'encapsulation d'une puce de circuit intégré. La puce 1 est collée au fond d'une cavité 2 d'un boitier, au moyen d'une colle de report 3 ; les plots de connexion de la puce sont électriquement raccordés par toute technique connue, par exemple par soudure de fils conducteurs 4 à des plages de connexion prévues à l'intérieur du boitier et ces plages sont interconnectées à des broches 5 (dans l'exemple des broches à souder) du connecteur d'interface du boitier. La cavité est ensuite hermétiquement fermée (scellée) par une plaque de fermeture 6. Lorsqu'il s'agit d'une puce de capteur d'image, la plaque de fermeture est ou intègre une fenêtre transparente au rayonnement utile (détecté par le capteur d'image) et cette fenêtre est située au-dessus de la surface photosensible. Plus généralement la plaque de fermeture est ou intègre une fenêtre transparente lorsque le composant doit émettre ou recevoir (détecter) un rayonnement optique. La fenêtre transparente est généralement pourvue d'une couche antireflet sur sa face interne et/ou sur sa face externe. Ce sont les couches respectivement référencées 7 et 8 sur la figure 1. Le scellement hermétique est assuré par un cordon de colle 9, présent tout le long de la partie supérieure de paroi périphérique 10 du boitier, qui relie la plaque à la paroi du boitier sur tout le tour. Ceci est obtenu de la façon suivante : on dépose, par sérigraphie par exemple, un cordon de colle de fermeture 9, pré-polymérisée, sur la face interne de la plaque (figure 2). La plaque munie de son cordon de colle est rapportée par-dessus la paroi du boitier, et le cordon de colle se trouve enserré entre la plaque et la partie supérieure plane de paroi 10. L'ensemble est mis sous presse et placé en étuve pour polymérisation/réticulation de la colle. Après polymérisation, le cordon de colle forme un joint hermétique étanche entre la plaque et le boitier. Son épaisseur est déterminée pour permettre d'absorber les déformations des matériaux de plaque et du boitier dont les coefficients de dilatation sont généralement différents.

La fabrication des composants destinés à l'aérospatiale doit respecter des normes très strictes, édifiées pour garantir une haute fiabilité de ces composants dans leurs conditions d'utilisation. Notamment, on sait que les différents matériaux de l'assemblage boitier/composant/plaque, notamment les colles, résines ou brasures, peuvent libérer des molécules de gaz dans les étapes en enceinte thermique. Cela impacte l'atmosphère dans la cavité ; si le boitier est métallique, cela favorise la corrosion. Il est donc habituel d'appliquer différentes mesures pour réduire/limiter la quantité de molécules de gaz dans la cavité après scellement (gaz résiduel). Notamment, on applique les mesures habituelles suivantes :
- un choix de matériaux (colles, résines...) qualifiés en raison de leurs compositions, c'est-à-dire la nature de leurs composés volatils/solvants (tests de qualification TML "*Total Mass Loss*" et CVCM "*Collected Volatile Condensible Materiar*"),
- un dégazage forcé des surfaces de l'assemblage, avant scellement, opéré par un passage en étuve (par exemple étuvage à quelques 150°C pendant une centaine d'heures), pour évacuer un maximum de composés volatils avant scellement,
- une étape de scellement de la plaque de fermeture sous atmosphère contrôlée, par exemple sous cloche hermétique, en atmosphère en gaz inerte (argon, azote) ou sous vide.

Différents tests sont utilisés pour vérifier que les composants tiennent les spécifications dictées par les normes. Un test de résistance thermique est notamment prévu pour vérifier et quantifier les effets de cycles de variation rapide de température sur les composants, et en particulier, non limitativement : leur durée de vie, l'herméticité ou étanchéité du boitier, le dégazage de composés volatiles, le durcissement de matériaux, les déformations mécaniques ou fissures ..., permettant de déterminer l'aptitude du composant à fonctionner correctement dans un environnement aérospatial. Pour ce test, les composants sont placés en enceinte thermique et on fait varier la température à l'intérieur de l'enceinte, suivant un cycle de variation plus ou moins abrupte, un certain nombre de fois. Par exemple, à chaque cycle, on fait varier la température entre -55°C et +125°C, avec une pente qui peut aller de quelques degrés à plus de 15 degrés par minute.

Lorsqu'il s'agit de qualifier un (nouveau) composant, le test impose un grand nombre de cycles de variation, par exemple 1000 cycles de variation de température. Après qualification, il faut encore tester les composants en sortie de chaine de fabrication : il s'agit alors de détecter les éventuels composants qui ne tiennent pas les spécifications permettant de garantir la durée de vie opérationnelle du composant. On utilise pour cela des tests de fiabilité qui sont des versions allégées des tests de qualification. Notamment le test de résistance thermique se limite alors à une dizaine de cycles.

### PROBLEME TECHNIQUE

Dans le cas de boitiers fermés par une plaque de fermeture à fenêtre transparente, on a pu constater lors du test de résistance thermique l'apparition d'une ou plusieurs taches, généralement blanchâtres, disséminées sur la face interne de la fenêtre de certains boitiers.

Ces taches sont révélatrices de la présence d'une certaine quantité de gaz à l'intérieur de la cavité fermée du boitier : ce sont des condensats de gaz piégés sur la face interne de la fenêtre transparente, et plus précisément, sur la couche antireflet revêtant cette face (si cette couche est en effet présente). C'est-à-dire que les taches observées correspondent à une condensation d'espèces gazeuses favorisée par les cycles de montées en température du test.

Ces taches peuvent être disséminées un peu partout : en bord de fenêtre ce qui peut ne pas être gênant ; ou plus au centre, et là, cela impacte très fortement la transmission des rayonnements utiles. On a pu montrer, par simulation, que la position des taches correspond à des chemins préférentiels vers des sites plus froids de la plaque. On a aussi constaté que la situation n'est pas figée : c'est-à-dire qu'aux taches observées à la fin du test de résistance thermique, peuvent s'en ajouter des nouvelles, en cours de fonctionnement opérationnel du composant.

Ainsi, lorsque que des taches apparaissent à la suite d'un test de résistance thermique, le composant concerné doit être mis au rebut, peu importe le nombre, l'étendue ou la position de ces taches. Et cela pose un réel problème de fiabilité et de coût de production des composants.

Suite à de nombreux essais, on a pu montrer que ces condensats de gaz n'étaient pas du à des défauts d'herméticité des composants, mais bien à des espèces dégazées par les surfaces à l'intérieur du composant lors du scellement, et lors des variations thermiques. C'est-à-dire que les cycles de montées en températures du test de résistance thermique rendent à nouveau possible un dégazage des matériaux de l'assemblage, à l'intérieur de la cavité.

Ainsi les mesures de précaution prises lors de l'encapsulation pour limiter la quantité d'espèces dégazées lors de l'encapsulation et le scellement, se révèlent insuffisantes pour empêcher la formation des taches blanches lors des tests thermiques ultérieurs et/ou au cours de l'utilisation en opérationnel, en fonction des conditions thermiques notamment.

On a pu aussi montrer, notamment par des essais de différentes combinaisons des matériaux de l'assemblage, que les espèces dégazées pendant ces cycles thermiques provenaient principalement de la colle de fermeture. On a trouvé une explication structurelle à cela : il existe de fait une grande surface d'échange entre la colle de fermeture et l'atmosphère de la cavité, en raison de la hauteur du cordon de colle et de la longueur de la paroi périphérique. Par comparaison, la surface d'échange entre la colle de report sous la puce et la cavité est bien moindre : l'épaisseur de colle de report est bien plus fine (elle ne sert qu'à coller, et éventuellement à réaliser un contact électrique, pas à réaliser un joint hermétique, étanche et apte à absorber des déformations mécaniques) ; et le tour de la puce est aussi moins long comparativement à la longueur de paroi.

On ne peut pas réduire l'épaisseur de colle de fermeture : le joint de colle après polymérisation doit avoir une certaine épaisseur, pour jouer son rôle d'absorption des déformations des matériaux de boitier et de plaque (coefficients de dilatation différents), sous contrainte opérationnelle (température). On ne peut pas non plus réduire la taille de la cavité, qui est déjà optimisée pour être la plus petite possible en fonction du composant, pour réduire l'encombrement du boitier. Enfin, on dispose de peu de compositions différentes de colle de fermeture qui satisfont aux tests de qualifications TML et CVCM pour l'aérospatiale ; et à l'issue des tests, aucune de ces compositions de colle ne s'est révélée significativement meilleure qu'une autre sur ce point. C'est-à-dire que des taches apparaissent dans tous les cas.

Il faut donc trouver d'autres solutions pour réduire encore plus la quantité d'espèces dégazées confinées à l'intérieur du boitier dans le but notamment de prévenir la formation de taches sur la fenêtre transparente de plaque.

Il est connu d'utiliser des matériaux "getters", capables de piéger en surface tout ou partie des gaz présents à l'intérieur de la cavité. Le terme "getter" (sorbeur en français) est le terme consacré dans la littérature technique. Ces matériaux getters sont bien connus. Le zirconium, le titane, le niobium, le vanadium sont des métaux couramment utilisés comme getters, seuls ou en alliages. Il s'agit de réaliser un matériau getter réactif aux espèces gazeuses présentes. Les demandes US2010/0025845 ou EP2004542 discutent de l'utilisation de tels matériaux getters, plus spécialement dans le contexte de puces de microsystèmes électromécaniques (MEMS). Notamment, l'efficacité de ces matériaux getter suppose une grande surface d'échange. Si on place le matériau getter au fond du boitier, à proximité de la puce, on augmente de façon notable les dimensions de la cavité. Pour résoudre la problématique grande surface d'échange/faible encombrement, on a pu proposer de former le matériau getter sur la surface interne de la plaque de fermeture. Cette solution ne convient généralement pas lorsque la puce doit détecter ou émettre un rayonnement à travers la plaque de fermeture. En outre, comme expliqué dans les demandes précitées, l'utilisation de matériaux getters amène d'autres considérations/contraintes : étapes supplémentaires de formation du matériau getter (structure de couche(s)) et adéquation avec les températures d'encapsulation/scellement, température d'activation de l'effet getter, saturation progressive de la surface des getters, ... Par ailleurs, les demandes EP1796168, EP1523045 ou EP 2164102 utilisent des techniques de fermeture par cavités ré-entrantes.

### RESUME DE L'INVENTION

L'invention se propose de résoudre le problème technique de dégazage d'espèces gazeuses à l'intérieur du boitier lors et après l'opération de scellement.

Selon l'art antérieur, comme expliqué en relation avec les figures 1 et 2, le scellement du boitier est réalisé par une plaque de fermeture et un cordon de colle entre la plaque de fermeture et la surface supérieure plane de la paroi périphérique, qui forme un joint sur toute la longueur périphérique de la paroi.

L'idée à la base de l'invention consiste en une modification du relief de la surface supérieure de paroi, de manière à ce que structurellement, le cordon de colle se retrouve isolé du côté intérieur de la cavité, et du côté extérieur du boitier, avec une surface à l'air libre, de manière à forcer le dégazage de colle vers l'extérieur du boitier via cette surface. Une structuration de la surface supérieure de paroi selon l'invention est efficace tant lors du scellement qu'après scellement. Elle est aisée et peu coûteuse à mettre en oeuvre et n'amène aucune contrainte particulière. Egalement, et c'est un avantage, elle n'influe par sur les dimensions du boitier, c'est-à-dire qu'elle peut être mise en oeuvre à dimensions constantes du boitier.

L'invention concerne donc un boîtier hermétique de circuit intégré comportant un fond, une paroi périphérique s'élevant à partir du fond qui définit une cavité intérieure du boitier et contient un circuit intégré et une plaque de fermeture collée sur la partie supérieure de la paroi périphérique. La partie supérieure de la paroi périphérique est une surface à relief comprenant d'une part une première zone plane en contact direct avec la plaque de fermeture, sans interposition de colle, sur toute la longueur de paroi périphérique du côté intérieur de la cavité, sauf là où des défauts de planéité empêchent le contact, et d'autre part, à l'extérieur de cette première zone plane, une zone de décrochement qui n'est pas en contact direct avec la plaque de fermeture. Un cordon de colle est présent dans la zone de décrochement et relie la plaque de fermeture et la partie supérieure de la paroi périphérique sur toute la longueur périphérique de celle-ci. Le cordon de colle présente une surface à l'air libre entre ladite plaque de fermeture et ladite zone de décrochement, sur le côté extérieur du boitier.

Idéalement, la première zone plane est en contact direct, sans interposition de colle, avec la plaque de fermeture sur toute la longueur de paroi périphérique. Mais, du fait de la longueur de paroi périphérique, des défauts de planéité des surfaces de plaque et paroi, peuvent empêcher le contact direct en certains endroits entre la première zone plane et la plaque de fermeture et dans ces endroits, le joint de colle a alors une surface, côté intérieur du boitier, qui est exposée à l'atmosphère à l'intérieur de la cavité. Mais la surface totale de joint exposée du côté intérieur du boitier du fait des défauts de planéité est bien moindre que la surface de joint de colle exposée à l'air libre du côté extérieur du boitier : le dégazage de colle se fait majoritairement vers l'extérieur du boitier. Ainsi, la structuration de la surface supérieure de la paroi périphérique du boitier qui est proposée dans l'invention a pour effet technique, si dégazage de colle de fermeture il y a, que ce soit lors de l'opération de scellement, lors des tests thermiques, voire sous contraintes opérationnelles, de forcer le dégazage de colle de fermeture principalement vers l'extérieur du boitier.

La zone de décrochement comprend une deuxième zone plane plus basse que la première zone plane.

Une troisième zone plane plus haute que la deuxième zone plane est prévue le long de la paroi du côté extérieur au boitier.

Selon un autre aspect de l'invention, la zone de décrochement s'étend jusqu'au bord extérieur de paroi et comporte une protubérance en relief à distance du bord extérieur de boitier.

Le flanc entre une zone plus haute (première ou troisième zone) et le fond de la zone de décrochement peut avoir un profil définissant une largeur de la zone plus haute qui va en s'élargissant depuis la surface supérieure en contact direct avec la plaque de fermeture vers le niveau de la zone de décrochement.

Avantageusement, la partie supérieure à relief de la paroi périphérique est un cadre, en métal ou en céramique.

L'invention mise en oeuvre pour l'encapsulation de capteurs d'image permet de résoudre le problème d'apparition des taches sur la fenêtre de plaque de fermeture. Mais on comprend bien qu'elle s'applique plus généralement à l'encapsulation en boitier hermétique de composants électroniques, puisqu'elle empêche le dégazage de la colle de fermeture vers l'intérieur de la cavité.

D'autres caractéristiques et avantages de l'invention apparaîtront à la lecture de la description détaillée qui suit et qui est faite en référence aux dessins annexés dans lesquels :
- la figure 1 illustre en coupe transversale un composant électronique en boitier hermétiquement fermé selon l'art antérieur ;
- la figure 2 représente la face interne d'une plaque de fermeture de boitier, à fenêtre transparente, munie de son cordon de colle de fermeture, en vue d'une opération de report pour scellement sur un boitier ;
- les figures 3 et 4 montrent une même vue partielle en coupe transversale d'un boitier, dans le sens de l'épaisseur de paroi périphérique du boitier, et détaillent une forme de relief de partie supérieure de paroi de boitier selon l'invention, avant (figure 3) et après scellement par la plaque de fermeture (figure 4) ;
- les figures 5 à 8 illustrent différents profils de relief de partie supérieure de paroi d'un boitier scellé selon l'invention.

### DESCRIPTION DETAILLEE

L'invention concerne donc un boitier d'encapsulation d'un composant électronique. Le boitier comprend une paroi périphérique qui s'élève depuis un fond du boitier et délimite une cavité. Il est fermé par une plaque de fermeture rapportée et collée sur la partie supérieure de paroi périphérique. Un cordon de colle relie la plaque de fermeture à la paroi périphérique sur toute la longueur de paroi.

Selon l'invention, la surface supérieure de paroi périphérique présente un relief tel que le cordon de colle est isolé du côté intérieur de la cavité, et du côté extérieur au boitier, présente une surface d'échange avec l'atmosphère extérieure du boitier.

Plus précisément le relief est défini par une zone plane surélevée tout le long de la paroi périphérique, du côté intérieur du boitier de la cavité et une zone de décrochement à l'extérieur de la zone plane surélevée. La zone plane est prévue pour être en contact direct avec la plaque de fermeture du boitier sur la totalité de la longueur de paroi périphérique, sans interposition de colle entre les deux, mais les défauts de planéité de surface sur cette longueur peuvent faire qu'elles soient légèrement espacées de place en place. La zone de décrochement n'est pas en contact direct avec la plaque de fermeture, et contient un cordon de colle qui relie la plaque de fermeture et la partie supérieure de la paroi périphérique sur toute la longueur périphérique de celle-ci. Le cordon de colle présente une surface à l'air libre entre la plaque de fermeture et la zone de décrochement, sur le côté extérieur du boitier. En cas de dégazage de la colle de fermeture, les espèces gazeuses sortent par cette surface vers l'extérieur du boitier.

Plusieurs réalisations peuvent être envisagées, qui vont être expliquées au moyen des figures 3 à 8. On notera que les figures n'ont pas été faites à l'échelle, pour mieux mettre en évidence les aspects de l'invention, notamment le relief de surface supérieure de paroi, la hauteur du relief correspondant en pratique à la hauteur (épaisseur) du cordon de colle à la fin de l'opération de scellement, de l'ordre d'une dizaine de microns. On notera également que dans un souci de simplification, les mêmes éléments ont les mêmes références dans l'ensemble des figures 1 à 8. Notamment, dans toutes les figures, la plaque de fermeture 6 illustrée est à fenêtre transparente à un rayonnement utile (pour le composant électronique, émetteur, ou récepteur). C'est-à-dire que la plaque peut être une plaque de verre, c'est-à-dire une vitre, entièrement transparente, comme illustré sur les figures ; ou bien la plaque peut intégrer une fenêtre transparente dans un cadre, qui peut être alors dans le même matériau que le boitier. Dans les figures, une couche antireflet est présente sur chacune des faces (couches 7 et 8 sur les figures), mais ce n'est pas obligatoire. Le boitier comprend une cavité 2 délimitée par une paroi périphérique 10 qui s'élève depuis un fond du boitier P. Un circuit intégré 1 (une puce nue dans l'exemple illustré) est collé au fond de cette cavité et électriquement raccordé aux broches du connecteur électrique du boitier, dans l'exemple via des fils 4 soudés et des plages d'interconnexion reliées à des broches du connecteur. La fermeture hermétiquement du boitier est assurée par un cordon de colle 9 qui relie la plaque et le boitier sur toute la longueur de paroi périphérique du boitier. Ces différents aspects de connexion et d'encapsulation sont bien connus et relèvent de techniques de connexions et encapsulation bien connues de l'homme de l'art.

L'invention va maintenant être expliquée en détail.

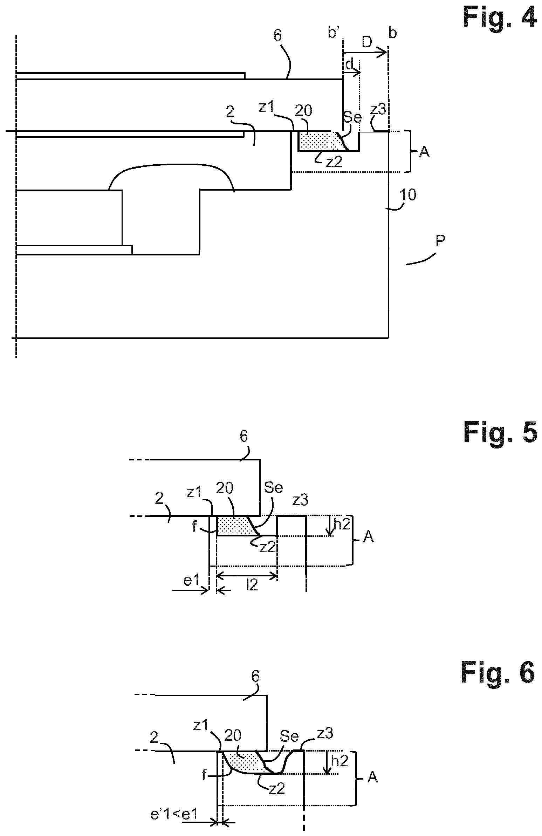

Un premier mode de réalisation de l'invention est représenté sur les figures 3 à 5. Dans cette réalisation, la surface de plaque de fermeture est plus petite que la surface de boitier délimitée par le bord externe de paroi périphérique. Autrement dit, comme visible sur la figure 4, le bord externe (b) de paroi périphérique 10 est en débord positif D par rapport au bord (b') de plaque de fermeture 6.

La figure 3 représente le boitier P et la plaque de fermeture 6 avant scellement. La plaque de fermeture 6 est munie d'un cordon de colle de fermeture 9 d'épaisseur déterminée h1. La colle a été déposée sous forme de pâte, par sérigraphie ou seringue. C'est un matériau thermodurcissable, généralement une résine, et peut être mono ou bicomposant.

Selon l'invention, la surface supérieure de paroi périphérique 10 du boitier n'est pas uniformément plane. C'est une surface structurée avec un relief formant une rainure réalisée sur toute la longueur de la paroi périphérique (qui fait le tour de la cavité). On a ainsi dans la largeur L de paroi périphérique, une zone z2 sensiblement plane de largeur 12 (la rainure) encadrée par deux zones planes surélevées de chaque côté : une zone surélevée z1 du côté intérieur du boitier et une zone surélevée z3 du côté extérieur au boitier.

La figure 4 montre le boitier hermétiquement fermé par la plaque, après scellement (passage en étuve sous presse, pour polymériser la colle de fermeture) et la figure 5 montre plus en détail l'assemblage de la plaque sur la partie supérieure A de paroi de boitier : la zone plane surélevée z1 est en contact direct, sans interposition de colle, avec la plaque de fermeture 6 ; mais on a expliqué que les deux parties (zone z1 et plaque 6) peuvent être espacées en certains endroits du fait de défauts de planéité des surfaces sur la longueur de paroi périphérique ; le cordon de colle est contenu entre le flanc f reliant la zone plane surélevée z1 au fond (zone z2) de la rainure, la face interne de plaque de fermeture 6 et le fond de la rainure (z2). La plaque de fermeture est espacée du fond de la rainure par l'épaisseur de colle ; et elle ne recouvre pas toute la largeur l2 de rainure : comme montré sur la figure, le bord intérieur b" de la zone plane surélevée z3 est en débord positif d (d<D) par rapport au bord b' de plaque. Ainsi, du fait du relief, le cordon de colle a une surface à l'air libre du côté extérieur du boitier qui sert de surface d'échange Se avec l'atmosphère extérieure du boitier.

La zone z3 peut servir de surface d'appui lors d'une intégration ultérieure du composant, dans un équipement système. Cette zone z3 peut être au même niveau que la zone z1 comme illustré ; mais elle pourrait aussi être plus haute ou un peu plus basse, selon les besoins exprimés par les équipementiers.

Du côté intérieur du boitier, la zone z1 forme avec la plaque de fermeture, une barrière mécanique isolante entre l'intérieur de la cavité (2) et le cordon de colle 9. La zone z1 est de préférence la plus étroite possible pour une surface d'adhérence de colle optimale sur la plaque 6. Les limites sont fonction des caractéristiques de résistance mécanique du matériau du boitier. Par exemple, pour un boitier céramique, la largeur e1 de la zone z1 pourra être de l'ordre du millimètre.

On peut avantageusement optimiser la surface d'adhérence de colle sur la plaque, en profilant le flanc de zone z1, côté rainure, de manière à élargir progressivement la largeur depuis la surface supérieure de la zone z1 en contact direct avec la plaque vers le fond de la rainure z2. Le profil peut être par exemple en S (sigmoïde) ou en biseau. Dans l'exemple d'un boitier céramique, la largeur e'1 de la zone z1 au niveau de la plaque de fermeture peut par exemple être de 100 microns, et atteindre quelques millimètres au niveau de la zone z2 (fond de la rainure).

Le profilage du flanc de zone z1 permet aussi avantageusement de s'adapter aux dimensions de la paroi, pour un composant donné, plus spécialement sa largeur L. On a vu que l'on cherchait à utiliser l'invention sans changer les dimensions de boitier. Selon les composants et les applications, la paroi périphérique peut être plus ou moins large. Or les dimensions de la zone z2 sont contraintes par les dimensions du cordon de colle après scellement (cuisson sous pression), pour avoir l'effet d'adhérence et d'étanchéité souhaité entre la plaque et le boitier. Les variables d'ajustement permettant de réaliser la zone z2 d'adhérence sont ainsi les largeurs et/ou profils des zones z1 et/ ou z3. Notamment la zone z3 peut être profilée avec un flanc raide ou bien en biseau, comme pour la zone z1.

L'épaisseur h1 de colle (avant chauffage sous pression) et les dimensions de la rainure h2, l2 sont définies en fonction des caractéristiques de la colle pour assurer les qualités d'adhérence et d'herméticité entre la plaque de fermeture et la paroi du boitier. Par exemple, la hauteur h1 de colle sur la plaque, avant scellement, est de 50 ou 80 microns (Figure 3) ; la rainure z2 a une profondeur h2 de l'ordre de 10 à 60 microns et une largeur l2 de l'ordre du millimètre, ou moins, par exemple 500 microns.

Dans l'étape de scellement, le cordon de colle de fermeture de la plaque est pressé contre le fond de la rainure et s'étale, comblant l'espace défini par le fond de rainure z2, le flanc f de la zone z1 et la plaque de fermeture, sans déborder sur la surface plane de zone z1 qui est plaquée en contact direct contre (ou proche de) la plaque de fermeture. A la fin de l'opération, la surface d'adhérence entre la plaque et la paroi de boitier comprend le flanc f, et une partie au moins de la largeur de rainure (cela pourrait être toute la largeur l2 de rainure), et cela assure un ancrage solide et hermétique de la plaque au boitier. L'homme du métier sait déterminer en fonction des caractéristiques de colle de fermeture, quelles hauteur et largeur de cordon à pré-déposer sur la plaque, et la position du cordon sur la plaque en fonction de la position et des dimensions de la rainure de paroi de boitier, pour obtenir les qualités d'adhérence et d'étanchéité désirées après l'opération de chauffage et pression qui se déroule ensuite. Dans l'opération de pression et chauffage, la colle s'écrase et s'étale dans l'espace délimité par la plaque, la zone de rainure z2 et le flanc f reliant cette zone z2 à la zone z1, et la plaque de fermeture s'appuie sur la surface de zone z1, sur toute la longueur périphérique de paroi, principalement en contact direct, sans interposition de colle. Dans les parties où le contact direct n'est pas possible du fait de défauts de planéité de surface, les deux parties restent proches, avec un espacement ne dépassant généralement pas 10 à 20 microns.

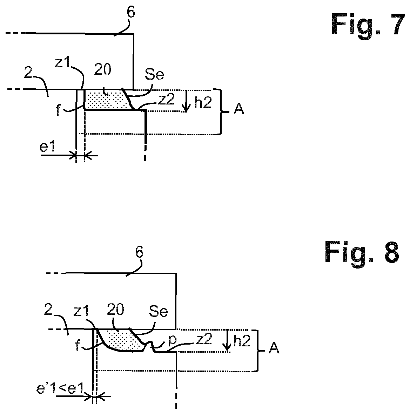

Les figures 7 et 8 montrent deux variantes de réalisation qui peuvent être utilisées lorsqu'il n'est pas prévu que le boitier propose sur le bord extérieur de paroi, une surface d'appui pour une intégration dans un équipement externe. Dans ce cas, il n'est pas nécessaire de prévoir la zone surélevée externe z3 des figures 3 à 6. La zone z2 se définit alors non plus comme une rainure, mais plus généralement comme une zone de décrochement z2 par rapport à la zone surélevée z1, qui s'étend jusqu'au bord extérieur de paroi. La colle peut alors s'étaler sur la largeur de zone de décrochement z2. Eventuellement, comme illustré sur la figure 8, on peut prévoir une petite protubérance 22 en relief dans la zone de décrochement z2, pour empêcher un étalement de la colle jusqu'au bord ou au-delà du bord de paroi. Dans les deux exemples de relief, avec ou sans protubérance, le front f reliant la zone z1 à la zone de décrochement z2 peut être assez abrupt (front raide des figures 5 et 7), ou profilé en biseau ou en S (figures 6 et 8), cette dernière variante permettant comme on l'a dit de réduire au mieux la largeur de surface de zone z1 en contact avec la plaque, sans fragiliser cette zone. Le flanc de zone z3 peut également être à front raide (figure 5) ou profilé en biseau ou en S.

Le relief de surface supérieure de paroi peut être facilement réalisée par usinage, gravure ou autres techniques adaptées pour former la zone de décrochement/rainure z2, et les profils désirés de la ou des zones surélevées en fonction du matériau de boitier (céramique ou métal, généralement).

Dans une variante, on peut réaliser de manière séparée la partie supérieure A de paroi délimitée en pointillé sur les figures 5 à 8, sous la forme d'un cadre, par exemple un cadre céramique ou encore un cadre métal, par exemple un cadre métal en Kovar (alliage Ni-Fe-Co). Le cadre est ensuite reporté et collé sur la surface plane de paroi supérieure de boitier, (avec une colle en couche très mince type colle de report de puce ou par brasure). Les espèces volatiles du cadre et de la colle ou brasure peuvent être majoritairement ou en totalité évacuées par l'opération de dégazage forcée, préalable au scellement, comme on l'a décrit. En pratique, la hauteur de cadre est déterminée en fonction de la hauteur h2 de relief, et des limites imposées par les techniques de moulage de forme de l'état de l'art. Par exemple, le cadre a une hauteur de quelques centaines de microns à quelques millimètres, par exemple entre 300 microns et 3 millimètres. Avec une telle forme de cadre réalisée de manière séparée, puis reportée, on s'évite ainsi les opérations de rectification de surface de paroi du boitier.

D'autres variantes de réalisation peuvent être envisagées. Par exemple la zone z3 peut ne pas être continue sur toute la longueur de paroi périphérique, mais présente par tronçons, formant autant de plots d'appui. Le profil de partie supérieure en coupe transversale est alors tantôt celui des figures 7 ou 8, et tantôt celui des figures 5 et 6. Egalement, lorsqu'il y a deux zones surélevées z1 et z3, le profil du flanc de l'une peut être différent de l'autre, selon les contraintes et les dimensions respectives. La réalisation sous forme de cadre séparée permet notamment de réaliser différentes variantes de profil, permettant d'adapter un boitier de composant standard, à des spécifications d'équipementiers différentes.

L'invention qui vient d'être expliquée et décrite à l'aide des figures, permet d'améliorer la fiabilité des composants en boitier hermétique, en forçant le dégazage de la colle de fermeture lors du scellement et après, vers l'extérieur du boitier, par la surface d'échange Se du côté extérieur du boitier. Notamment, dans le contexte de composants détecteur ou émetteur de rayonnement, les capteurs d'image notamment, on prévient efficacement la formation de taches sur la fenêtre transparente de plaque. On améliore ainsi la fiabilité de ces composants pour les utilisations en aérospatiale. L'invention peut s'appliquer plus largement. Elle ne se limite pas à l'encapsulation d'un type de composant électronique particulier, ni à un boitier à fenêtre transparente. On a expliqué que les gaz résiduels à l'intérieur des boitiers de composants électroniques sont problématiques à bien des égards. La solution technique apportée par l'invention, simple et peu coûteuse à mettre en oeuvre peut donc s'appliquer de façon générale aux boitiers hermétiques de composants électroniques dès qu'il est utile ou nécessaire d'empêcher une dégradation des surfaces, y compris la surface interne de plaque de fermeture (dégradation de la transparence) et/ou de maîtriser l'atmosphère (pression) à l'intérieur de la cavité.

Dans le contexte des applications aérospatiales, le boitier est généralement un boitier céramique, mais il peut aussi être en métal. Dans les deux cas, le relief pourra être obtenu par usinage (gravure) de surface par tous moyens adaptés, ou par report d'un cadre comme indiqué. Mais le principe de l'invention trouve aussi à s'appliquer à des boitiers plastiques. La forme de relief sera alors généralement obtenue par moulage.

La plaque de fermeture, quand elle n'est pas entièrement transparente (fenêtre dans un cadre), peut être réalisée pour la partie non transparente dans le même matériau que le boitier.

## Revendications

1. Boîtier hermétique de circuit intégré comportant un fond, une paroi périphérique (10) s'élevant à partir du fond et définissant une cavité (2) intérieure du boitier, un circuit intégré dans la cavité, et une plaque de fermeture (6) collée sur la partie supérieure de la paroi périphérique qui ferme hermétiquement la cavité, le boîtier fermé étant tel que
- la surface supérieure de la paroi périphérique présente un relief comprenant d'une part une première zone plane (z1) en contact direct avec la plaque de fermeture, sans interposition de colle, sur toute la longueur de paroi périphérique du côté intérieur de la cavité, sauf là où des défauts de planéité empêchent le contact, et d'autre part, à l'extérieur de cette première zone plane, une zone de décrochement (z2) qui n'est pas en contact direct avec la plaque de fermeture,
- un cordon de colle (9) de fermeture est présent dans la zone de décrochement et relie la plaque de fermeture et la partie supérieure de la paroi périphérique sur toute la longueur périphérique de celle-ci, et
- le cordon de colle (9) de fermeture présente une surface (Se) à l'air libre entre la plaque de fermeture et la zone de décrochement, sur le côté extérieur du boitier
dans lequel la zone de décrochement comprend une deuxième zone plane (z2) plus basse que la première zone plane (z1),
dans lequel le relief de surface supérieure de la paroi périphérique comprend une troisième zone plane (z3) le long de la paroi du côté extérieur au boitier, et la deuxième zone plane est plus basse que la troisième zone plane,
le boîtier étant **caractérisé en ce que** le flanc entre la zone de décrochement, et la première zone plane et/ou entre la zone de décrochement et la troisième zone plane, a un profil tel que la largeur de paroi périphérique va en s'élargissant depuis le niveau de la surface supérieure de la zone plane plus haute vers le niveau de la zone plane de décrochement (z2).

2. Boitier hermétique selon la revendication 1, dans lequel la zone de décrochement s'étend jusqu'au bord extérieur de paroi et comporte une protubérance (p) en relief à distance du bord extérieur de boitier.

3. Boitier hermétique selon l'une quelconque des revendications précédentes, en céramique ou en métal.

4. Boitier hermétique selon l'une quelconque des revendications précédentes, dans lequel la partie supérieure de paroi (A) présentant la surface à relief est un cadre.

5. Boitier hermétique selon l'une quelconque des revendications 1 à 4, dans lequel la plaque de fermeture est ou comprend une fenêtre transparente à un rayonnement utile.

6. Boitier hermétique selon l'une quelconque des revendications 1 à 4, dans lequel la plaque de fermeture est une plaque de verre.

7. Boitier hermétique selon la revendication 5 ou 6, pour un capteur d'image.

## Patentansprüche

1. Hermetisches Gehäuse für eine integrierte Schaltung mit einem Boden, einer Umfangswand (10), die sich vom Boden aus erhebt und einen inneren Hohlraum (2) des Gehäuses definiert, einer integrierten Schaltung in dem Hohlraum und einer Verschlussplatte (6), die auf den oberen Teil der Umfangswand geklebt ist und den Hohlraum hermetisch verschließt, wobei das geschlossene Gehäuse so beschaffen ist, dass
- die obere Fläche der Umfangswand ein Relief umfasst, das einerseits einen ersten ebenen Bereich (z1) in direktem Kontakt mit der Verschlussplatte ohne Zwischenschaltung von Klebstoff über die gesamte Länge der Umfangswand auf der Innenseite des Hohlraums umfasst, außer dort, wo Unebenheiten den Kontakt verhindern, und andererseits außerhalb dieses ersten ebenen Bereichs einen abgesetzten Bereich (z2), der nicht in direktem Kontakt mit der Verschlussplatte steht,
- eine Verschlussklebstoffraupe (9) in dem abgesetzten Bereich vorhanden ist und die Verschlussplatte und den oberen Teil der Umfangswand über deren gesamte Umfangslänge miteinander verbindet, und
- die Verschlussklebstoffraupe (9) eine an der Luft liegende Oberfläche (Se) zwischen der Verschlussplatte und dem abgesetzten Bereich an der Außenseite des Gehäuses aufweist,
wobei der abgesetzte Bereich einen zweiten ebenen Bereich (z2) umfasst, der niedriger als der erste ebene Bereich (z1) ist,
wobei das Relief der oberen Fläche der Umfangswand einen dritten ebenen Bereich (z3) entlang der Wand an der Außenseite des Gehäuses umfasst und der zweite ebene Bereich niedriger ist als der dritte ebene Bereich,
wobei das Gehäuse **dadurch gekennzeichnet ist, dass** die Flanke zwischen dem abgesetzten Bereich und dem ersten ebenen Bereich und/oder zwischen dem abgesetzten Bereich und dem dritten ebenen Bereich ein solches Profil hat, dass die Breite der Umfangswand von der Höhe der oberen Fläche des höheren ebenen Bereichs bis zu der Höhe des abgesetzten ebenen Bereichs (z2) hin breiter wird.

2. Hermetisch abgedichtetes Gehäuse nach Anspruch 1, wobei sich der abgesetzte Bereich bis zum äußeren Rand der Wand erstreckt und einen erhabenen Vorsprung (p) in einem Abstand vom äußeren Rand des Gehäuses aufweist.

3. Hermetisches Gehäuse nach einem der vorhergehenden Ansprüche, bestehend aus Keramik oder Metall.

4. Hermetisches Gehäuse nach einem der vorhergehenden Ansprüche, wobei der obere Wandabschnitt (A) mit der erhabenen Oberfläche ein Rahmen ist.

5. Hermetisches Gehäuse nach einem der Ansprüche 1 bis 4, wobei die Verschlussplatte ein für eine Nutzstrahlung durchlässiges Fenster ist oder umfasst.

6. Hermetisches Gehäuse nach einem der Ansprüche 1 bis 4, wobei die Verschlussplatte eine Glasplatte ist.

7. Hermetisches Gehäuse nach Anspruch 5 oder 6 für einen Bildsensor.

## Claims

1. An hermetic integrated-circuit casing having a bottom, a peripheral wall (10) rising from the bottom and defining an interior cavity (2) of the casing, an integrated circuit in the cavity, and a closing plate (6), which is adhesively bonded to the upper portion of the peripheral wall, hermetically closing the cavity, the casing being such that
- the upper surface of the peripheral wall has a relief comprising, on the one hand, a first planar zone (z1) that makes direct contact with the closing plate, without interposition of adhesive, over the entire length of the peripheral wall on an interior side of the cavity, except where planarity defects prevent contact, and on the other hand, on the exterior of this first planar zone, a recessed zone (z2) that is not in direct contact with the closing plate,
- an closing adhesive bead (9) is present in the recessed zone and joins the closing plate and the upper portion of the peripheral wall over the entire peripheral length of the latter, and
- the closing adhesive bead (9) has a surface (Se) in open air between the closing plate and the recessed zone, on the exterior side of the casing,
wherein the recessed zone comprises a second planar zone (z2) that is lower than the first planar zone (z1),
wherein the relief in the upper surface of the peripheral wall comprises a third planar zone (z3) along the wall on the exterior side of the casing, and the second planar zone is lower than the third planar zone,
the casing being **characterised in that** the flank between the recessed zone, and the first planar zone and/or between the recessed zone and the third planar zone, has a profile such that the width of the peripheral wall increases with distance from the level of upper surface of the highest planar zone to the level of the planar recessed zone (z2).

2. The hermetic casing according to claim 1, wherein the recessed zone extends as far as to the exterior wall edge and has a protuberance (p) in relief at a distance from the exterior casing edge.

3. The hermetic casing according to any one of the preceding claims, made of ceramic or made of metal.

4. The hermetic casing according to any one of the preceding claims, wherein the upper wall portion (A) having the relief-containing surface is a frame.

5. The hermetic casing according to any one of claim 1 to 4, wherein the closing plate is or comprises a window that is transparent to useful radiation.

6. The hermetic casing according to any one of claim 1 to 4, wherein the closing plate is a glass plate.

7. The hermetic casing according to claim 5 or 6, for an image sensor.
